# EUROPEAN PATENT APPLICATION

(11) **EP 1 361 684 A1**
(43) Date of publication of application: **12.11.2003**
(21) Application number: 02253222.0
(22) Date of filing: 08.05.2002
(51) Int. Cl.: H04B 10/158, G02F 3/00

(54) **High-speed burst-mode opto-electronic receiver**

(71) Applicant: LUCENT TECHNOLOGIES INC., Murray Hill, New Jersey 07974-0636 (US)
(72) Inventor: Jennen, Gerardus, 1273 BT Huizen (NL); Smets, Rob C., Weesp (NL)
(74) Representative: Sarup, David Alexander

(57) **Abstract**

The invention relates to a burst receiver for receiving an optical burst-mode signal (1), comprising signals with different power levels, originating from different senders. The burst receiver (10) comprises first conversion means (13, 14), that are arranged for receiving the input signal (1) and providing an inverted and a non-inverted optical signal (5, 4). These inverted and non-inverted optical signals (5, 4) are applied to a balanced receiver (6). The balanced receiver (10) provides an electrical output signal (9) corresponding to the difference between the inverted and non-inverted optical signal (5, 4).

## Description

### FIELD OF THE INVENTION

The invention relates to a burst-mode receiver for receiving an optical burst-mode input signal.

### BACKGROUND

Future optical communication links are likely to operate on burst-mode traffic, e.g. based on transfer of data packets. This means that no longer synchronous connections will be used between network nodes. These links will be replaced by a-synchronous connections, for instance by the use of Time Division Multiple Access (TDMA) techniques. The reason for this is that such a scheme fits the packet oriented network of the future.

The use of burst-mode techniques requires fast and accurate handling of the incoming signals by the optical line termination and accurate handling of the optical power levels both on the transmitter and the receiver sides.

A problem that occurs when processing burst-mode signals is that signals originating from different optical network units may have different power-levels, as a consequence of different transmission levels, different distances between different optical network units and the optical line termination and the variation of temperature conditions. The difference between power levels of the burst signals makes it difficult for the high-speed burst-mode receiver to distinguish between a bit representing a '0' and a bit representing a '1', because the '0'-level of a first optical network unit can be close to the '1'-level of a second one.

A solution to this problem of varying amplitudes is disclosed in *A SiGe BiCMOS Burst-mode 155 Mb*/*s Receiver for PON,* by S. Brigati et al, paper downloaded from the internet at April 9 2002:
http://www.eurotraining.net/ESSCIRC 2001/esscirc 2001/data/86.pdf.
In this paper the receiver of the burst-mode signals originating from different optical network units handles the varying amplitudes by applying different reference levels to the receiver circuitry, depending on which optical network unit the signals are received from. In ATM PON systems, each optical network unit can only transmit during a predetermined timeslot, so the receiver knows when to expect signals from each optical network unit and accordingly knows what reference level should be applied at which time. Also a reference level is applied that is indicative of the variance due to temperature conditions. With the aid of these reference signals, the receiver can correctly distinguish between a '0' and a '1'-bit received from different optical network units.

This however, requires active elements in the burst receiver that constantly monitor the incoming data. Also, changes in the field, such as a new optical network unit, need to be accounted for in the optical line termination. The electronic circuits required to implement this method are very complex and expensive.

Another solution to the problem is disclosed in *Decision Threshold Based on Dynamic Offset Compensation for Burst Mode Receiver,* by T. den Bakker, Kun-Yii Tu and Y.K. Park: Proceedings of the ECOC 2001 in Amsterdam, The Netherlands, p. 123-124. The threshold value Vₜₕ, above which the signal is considered to represent a '1'-bit and below which the signal is considered to represent a '0'-bit, is constantly adjusted based on the value of the incoming signal. The threshold value equals: Vₜₕ = V_{sig}/2, where V_{sig} is the peak value of the incoming signal. Also an offset is added to the Vₜₕ if V_{sig} is zero, in order to prevent chattering. However, this technique requires active electronic components in the optical line termination and constant monitoring of the incoming signal.

### SUMMARY OF THE INVENTION

The present invention seeks to provide a burst-mode receiver that allows to receive burst-mode packets having uncertain power levels. Furthermore, the present invention seeks to provide a solution, which does not require complex and expensive electronic circuits.

According to the present invention, a burst receiver is provided of the type defined in the preamble above, in which the receiver comprises first conversion means arranged for receiving the input signal and providing an inverted and a non-inverted optical signal, and a balanced receiver arranged for receiving the inverted and non-inverted optical signal and providing an electrical output signal corresponding to the difference between the inverted and non-inverted optical signal. Such a burst receiver is capable of supporting all digital data streams, regardless of the power level. Also, such a burst receiver is capable of high-speed reception, up to more than 10 Gb/s and beyond.

In a further embodiment, the first conversion means are arranged to provide an inverted and a non-inverted optical signal having a predetermined DC-power level. The predetermined DC-power level may be 0V, which allows to use very simple detection logic for discriminating '0' and '1'-levels. Consequently, a receiver results which is independent on the average received optical power.

The first conversion means may in a further embodiment be arranged to provide an inverted and a non-inverted optical signal of which the respective '1' and '0'-power levels are equal. This allows to obtain an optimum receiver performance.

The first conversion means may in a further embodiment comprise at least one wavelength conversion element receiving an optical continuous wave signal at a first wavelength and the input signal at a second wavelength and outputting an inverted and/or non-inverted optical signal at the first wavelength. In case the burst receiver is also used as a transmitter, the optical continuous wave signal can, for instance, be the continuous wave signal used for transmission. The wavelength thereof may even be the same as the received wavelength when a counter propagating continuous wave signal with respect to the received signals is used. This allows for an easy implementation of the present invention.

The balanced receiver of the burst-mode receiver may comprise two photodiodes connected in series for receiving the inverted and non-inverted optical signal, respectively. This embodiment allows for a very easy and cost-effective implementation. The wavelength conversion element may comprise a first Semiconductor Optical Amplifier receiving the optical continuous wave signal at a first input port and the optical signal at a second input port; a second Semiconductor Optical Amplifier receiving the optical continuous wave signal at a first input port; a 2x2 coupler connected to an output port of the first and second Semiconductor Optical Amplifier, respectively, providing the inverted and non-inverted optical signal at respective output ports. This embodiment allows easy and cost-effective implementation using off-the-shelf optical components, but becomes cost efficient when integrated into a single chip/module. Also, this embodiment has the benefit of improved noise properties because the amplified stimulated emission of the Semiconductor Optical Amplifier -based Mach-Zehnder interferometer is at least partly cancelled out by the balanced receiver. Additional, known signal regenerating properties of the Mach Zehnder structure will improve overall receiver performance.

The elements of the burst-mode receiver may in a still further embodiment be integrated in a single device. Such a burst receiver allows for a compact solution.

Also the optical and electronic elements of the burst-mode receiver may be integrated in a single device. Such a burst receiver allows for an even more compact solution, using known fabrications techniques.

### SHORT DESCRIPTION OF THE DRAWINGS

The present invention will now be discussed in more detail using a number of exemplary embodiments, with reference to the drawings, which are only intended to illustrate the present invention and not to limit its scope which is only limited by the appended claims:
Figure 1a-d show graphs of the signal in different phase of processing according to the present invention.
Figure 2 shows a schematic diagram of a preferred embodiment of the present invention.
Figure 3 shows a schematic diagram of an embodiment of a balanced optical receiver of the present invention.
Figure 4 shows a schematic diagram of an embodiment of a wavelength conversion element according to the present invention.

### DETAILED DESCRIPTION

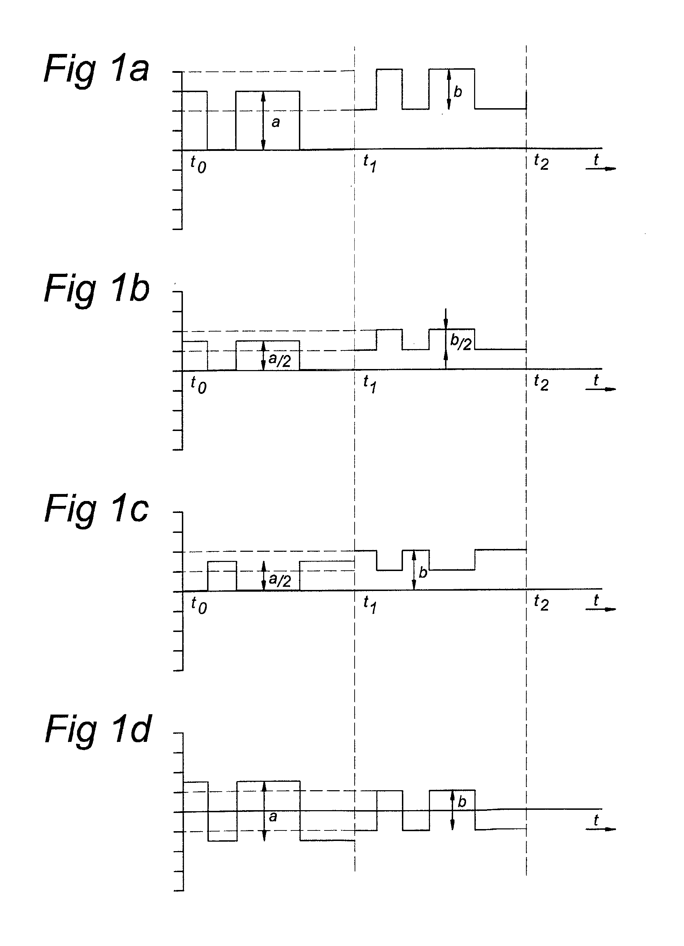

Figure 1a shows a graph of a possible optical signal 1 that is received by an optical receiver 10 in an optical communication network. Signal 1 is for instance an optical burst-mode signal, received from different transmitters using a time division multiplex access (TDMA) technique to allow sharing of a single optical communication channel.

Signal 1 in Fig. 1a comprises two successive signals: a signal A from a first transmitter and a signal B from a second transmitter, occupying timeslots t₀-t₁ and t₁-t₂ respectively. Both signal A and signal B represent a digital signal comprising '0' and '1'-bits.

However, signal B has different amplitudes and also has a different DC-component than signal A. The fact that the '0'-value of signal B is close to the '1'-value of signal A, will cause problems to a receiver trying to distinguish between a '0' and a '1'-bit. The uncertain optical power levels for the '0' and the '1'-bit signals may e.g. originate from different distances between the first transmitter and the receiver and the second transmitter and the receiver, and/or from different optical losses in the respective communications paths.

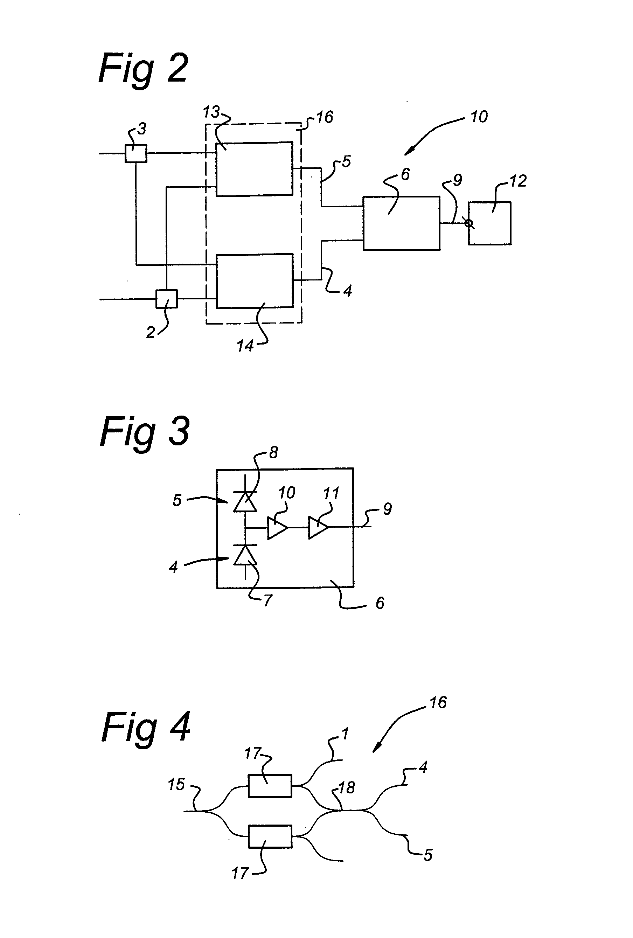

Figure 2 shows a first preferred embodiment of the present invention. The optical signal 1 to be received and processed in the optical receiver 10 is input to a first beam splitter 2 to obtain two equal signals at half the optical power. Signal 1 has a wavelength λₒ, so accordingly, both the equal signals at half the power have the same wavelength λₒ. Figure 1b shows such a signal at half the optical power.

The two signals are input to an inverting element 13 and a non-inverting element 14 to obtain an inverted signal 5 and a non-inverted optical signal 4, respectively. In this case, the non-inverting element 14 does not change the received signal. The inverted signal 5 however, is inverse to signal 4, but has the same DC-component as the non-inverted signal 4. An example of the inverted signal 5 is depicted in figure 1c. The inversion can best be understood by comparing figure 1c with figure 1b.

These signals 4, 5 are then input to a balanced optical receiver 6. The balanced optical receiver effectively provides an electrical signal 9 at its output, which is centered around a preset voltage, e.g. 0V, as is shown in figure 1d.

The electrical signal 9 is then input to a burst receiver 12, which is arranged to sample the electrical signal 9 with a threshold level of e.g. 0V, allowing easy detection of the '0' and '1'-levels of the input optical signal 1.

An example of such a balanced optical receiver 6, as depicted in figure 3, comprises two photodiodes 7, 8, connected in series, with the cathode of the lower photodiode 7 connected to the anode of the upper photodiode 8, where signal 4 is applied to the first photodiode 7 of the balanced receiver 6 and signal 5 is applied to the second photodiode 8 of the balanced receiver 6. Such photodiodes 7, 8 are known to a person skilled in the art and induce a current that among other parameters is depending on the amount of light that impinges on the photodiodes 7, 8.

An electrical signal 9 taken from the connection between the first and the second photodiode 7, 8 corresponds to the difference between signal 4 and signal 5. The signal 9 is centered around zero, and has accordingly a DC-component of zero.

The electrical signal 9 can be further applied to a transimpedance amplifier 10 and a limiting amplifier 11. Important is that this limiting amplifier does not see a DC-component. Signal 9 can then be further applied to a demultiplexer 12, where sampling and synchronization can be done to further process the signal 9. Of course, all kinds of processing units can be used here, known to a person skilled in the art, to allow interfacing with signal processing electronics, such as a demultiplexer 12 , for e.g. SDH/SONET applications. Conventional AC-coupled limiting amplifiers can be used to limit the signal levels to allow easy and robust interfacing with signal processing electronics.

As can be seen in figure 1d, the signal 9 is centered around zero. Because the DC-component of signal 9 equals zero, the demultiplexer 12 can easily distinguish between parts of the signal 9 representing a 1-bit and parts of the signal representing a 0-bit, because the same threshold (namely zero) can be used for signal A and signal B.

Best results are obtained if the amplitude levels of the signal 2 are equal to the amplitude level of the signal 5. This means that the high '1' and low values '0' of signal 2 are equal to the high '1' and low '0' values of signal 5.

An effective way to implement the inverting element 13 and non-inverting element 14 in the optical domain is by using wavelength converters, which as such are known to the person skilled in the art. In this embodiment, also a continuous wave signal 15 is required, which has a wavelength of λₓ (see figure 2). This signal is split in a first and a second part by an optical splitter 3. One of the two equal input signals is applied to a non-inverting wavelength converter 14 together with the first part of the continuous wave signal 15. The wavelength converter 14 converts the input signal into a signal 4 having a carrier wavelength λₓ and a predetermined DC-component.

The other input signal is applied to an inverting wavelength converter 13 together with the second part of the continuous wave signal 15. The inverting wavelength converter 13 outputs a signal 5, where signal 5 has a carrier wavelength λₓ, and is inverse to signal 4, but has the same DC-component. When signal 4 is high compared to the DC-component, signal 5 is low compared to the DC-component.

According to a different embodiment, the inverting wavelength converter 13 and the non-inverting converter 14 can both be integrated in one single wavelength converter 16. Signal 1 and signal 15 are both applied to that single wavelength converter 16. This allows a compact solution.

According to yet another embodiment, the inverting wavelength converter 13, the non-inverting wavelength converter 14, and the first and second beam splitter 2, 3 are all integrated in one single device, so even a more compact solution is provided.

In case the arrangement is not only used for receiving signals, but also for transmitting signals, the transmitter wavelength signal can be used as the continuous wave signal 15 which has a wavelength of λₓ. In that case, no additional laser is needed. The wavelength might even be the same as the received wavelength λ₀ when a counter propagating continuous wave signal with respect to signals 2, 3 is used.

Figure 4 shows a schematic diagram of a possible implementation of the wavelength conversion element used in the present invention, using a Mach Zehnder interferometer based on the use of Semiconductor Optical Amplifiers (SOA-based Mach Zehnder-interferometer 16). The SOA-based Mach Zehnder-interferometer 16 comprises a 2x2 coupler 18, that is connected to output ports of two Semiconductor Optical Amplifier (SOA) 17. The use of a 2x2 coupler 18 and SOA's 17 is known to a person skilled in the art. The continuous wave signal 15 which has a wavelength of λₓ is applied to an input port of both the SOA's 17. Splitting of signal 15 can be done using a 1x2 coupler, as is shown in figure 4, or can be done using a 2x2 coupler (not shown), where signal 15 is applied to one input, both couplers are known to a person skilled in the art.

However, the burst-mode signal 1 is applied to a second input port of the first SOA 17 only, while it is not supplied to the second SOA 17. The output signals of both the SOA's 17 are applied to the 2x2 coupler 18. As a result, the non-inverted signal 4 appears on one output port of the 2x2 coupler 18 and the inverted signal 5 appears on the other output port of the 2x2 coupler 18, as will readily be understood by a person skilled in the art.

This embodiment provides improved noise properties because the amplified stimulated emission of the SOA-based Mach Zehnder-interferometer is at least partly cancelled by the balanced receiver.

This embodiment has the potential of being integrated with the balanced receiver 6 and an electrical demultiplexer 12 on a single chip or single package/module, using known semi-conductor production techniques.

The present invention can be used in high-speed optical networks that for instance use burst-mode techniques. The invention is capable of processing speeds beyond the 10 Gb/s. This is possible because the conversion of the signal is done in the optical domain instead of the electrical domain.

For the purpose of teaching the invention, preferred embodiments of the method and devices of the invention were described. It will be apparent for the person skilled in the art that other alternative and equivalent embodiments of the invention can be conceived and reduced to practice without departing from the true spirit of the invention, the scope of the invention being only limited by the annexed claims.

## Claims

1. Burst-mode receiver for receiving an optical burst-mode input signal (1),
**characterised in that** the receiver (10) comprises
first conversion means (13, 14) arranged for receiving the input signal (1) and providing an inverted and a non-inverted optical signal (5, 4), and
a balanced receiver (6) arranged for receiving the inverted and non-inverted optical signal (5, 4) and
providing an electrical output signal (9) corresponding to the difference between the inverted and non-inverted optical signal (5, 4).

2. Burst-mode receiver according to claim 1, **characterised in that** the first conversion means (13, 14) are arranged to provide an inverted and a non-inverted optical signal (5, 4) having a predetermined DC-power level.

3. Burst mode receiver according to claim 1 or 2, **characterised in that** the first conversion means (13, 14) are arranged to provide an inverted and a non-inverted optical signals (5, 4) of which the respective '1' and '0' power levels are equal.

4. Burst mode receiver according to any of the preceding claims, **characterised in that** the first conversion means (13, 14) comprise at least one wavelength conversion element receiving an optical continuous wave signal (15) at a first wavelength and the input signal (1) at a second wavelength and outputting an inverted and/or non-inverted optical signal (5, 4) at the first wavelength.

5. Burst mode receiver according to any of the preceding claims, **characterised in that** the balanced receiver (6) comprises two photodiodes (7, 8) connected in series for receiving the inverted and non-inverted optical signal (5, 4), respectively.

6. Burst mode receiver according to claim 4, **characterised in that** the wavelength conversion element comprises
a first Semiconductor Optical Amplifier (17) receiving the optical continuous wave signal (15) at a first input port and the optical signal (1) at a second input port;
a second Semiconductor Optical Amplifier (17) receiving the optical continuous wave signal (15) at a first input port;
a 2x2 coupler (18) connected to an output port of both the first and second Semiconductor Optical Amplifier (17), respectively, providing the inverted and non-inverted optical signal (5, 4) at respective output ports.

7. Burst mode receiver according to any of the preceding claims, in which the elements of the burst-mode receiver (10) are integrated in a single device.

8. Burst mode receiver according to any of the preceding claims, in which the optical and electronic elements of the burst-mode receiver (10) are integrated in a single device.
